(19) Europäisches Patentamt
European Patent Office
Office européen des brevets

(11) **EP 0 726 647 B1**

(12) **EUROPÄISCHE PATENTSCHRIFT**

(45) Veröffentlichungstag und Bekanntmachung des Hinweises auf die Patenterteilung:
**14.06.2000 Patentblatt 2000/24**

(51) Int Cl.$^7$: **H03F 3/08**

(21) Anmeldenummer: **96101081.6**

(22) Anmeldetag: **25.01.1996**

(54) **Transimpedanzverstärkerschaltung**

Transimpedance amplifier circuit

Circuit amplificateur transimpédance

(84) Benannte Vertragsstaaten:
**DE DK FR GB IT**

(30) Priorität: **09.02.1995 DE 19504290**

(43) Veröffentlichungstag der Anmeldung:
**14.08.1996 Patentblatt 1996/33**

(73) Patentinhaber: **SIEMENS AKTIENGESELLSCHAFT**
**80333 München (DE)**

(72) Erfinder: **Wilhelm, Wilhelm, Dr. Ing.**
**D-81477 München (DE)**

(56) Entgegenhaltungen:
**US-A- 3 931 583**     **US-A- 4 352 982**
**US-A- 5 030 925**

**Beschreibung**

Die Erfindung betrifft eine Transimpedanzverstärkerschaltung mit einem invertierenden Spannungsverstarker, dessen Eingang durch einen Eingangsstrom gespeist wird und dessen Ausgang eine Ausgangsspannung führt, und mit einem Kopplungsglied, das zwischen Eingang und Ausgang des Spannungsverstärkers geschaltet ist.

Eine derartige Transimpedanzverstärkerschaltung ist beispielsweise aus U. Tietze, Ch. Schenk, Electronic Circuits-Design and Applications, Berlin, Heidelberg 1991, Seite 97 bekannt, wobei als Kopplungsglied ein ohmscher Widerstand vorgesehen ist. Transimpedanzverstärker setzen einen Eingangsstrom in eine proportionale Spannung um und werden daher in der Regel zur Verstärkung der von Fotodioden erzeugten Ströme verwendet. Dieser Strom kann zum einen sehr klein - z.B. 1μA- oder auch im Vergleich dazu sehr groß -beispielsweise 1mA- sein. Daraus ergeben sich Dimensionierungsprobleme, die insbesondere auf den bei der bekannten Lösung in der Rückkopplungsschleife verwendeten ohmschen Widerstand zurückzuführen sind.

Der Widerstand muß klein sein, um bei großen Strömen eine Übersteuerung des Transimpedanzverstärkers zu vermeiden. Damit steigt aber das Eingangsrauschen des Transimpedanzverstärkers, da kleinere Widerstände größere thermische Rauschströme erzeugen. Kleinere Widerstände bewirken auch eine Reduzierung der Empfindlichkeit, so daß kleine Eingangsströme im Rauschen untergehen. Damit wird aber insgesamt der Dynamikbereich des Transimpedanzverstärkers stark eingeschränkt.

Aufgabe der Erfindung ist es daher, eine Transimpedanzverstärkerschaltung mit größerem Dynamikbereich anzugeben.

Die Aufgabe wird bei einer Transimpedanzverstärkerschaltung der eingangs genannten Art dadurch gelöst, daß das Kopplungsglied zwei Dioden aufweist, die antiseriell zueinander zwischen Eingang und Ausgang des Spannungsverstärkers geschaltet sind und deren gemeinsamer Knotenpunkt über die Laststrecke eines Transistors mit einem Bezugspotential verbunden ist, daß an Eingang und Ausgang des Spannungsverstärkers je einer der beiden Eingänge eines Differenzverstärkers angeschlossen ist, und daß ein dem Differenzverstärker nachgeschalteter Tiefpaß an seinem Ausgang ein Ansteuersignal für den Transistor bereitstellt.

Die erfindungsgemäße Transimpedanzverstärkerschaltung hat den Vorteil, daß sie den Rückkopplungswiderstand entsprechend der Größe des Eingangssignals anpaßt. Dies geschieht mit Hilfe von Diodenstrecken, die durch einen Gleichstrom, der proportional dem Gleichanteil des Eingangsstroms ist, vorgespannt werden und so für die nötige Änderung des dynamischen Widerstandes sorgen. Die Nichtlinearität der Dioden wird durch den nachgeschalteten Differenzverstärker kompensiert, so daß im gesamten Widerstandsbereich keine Linearitätsfehler auftreten.

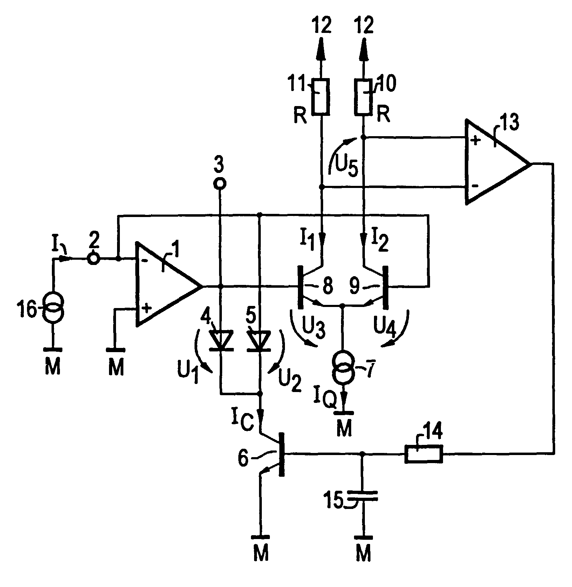

Die Erfindung wird nachfolgend anhand des in der einzigen Figur der Zeichnung dargestellten Ausführungsbeispiels näher erläutert.

Bei dem in der Zeichnung gezeigten Ausführungsbeispiel ist ein invertierender Spannungsverstärker vorgesehen, der beispielsweise durch einen Operationsverstärker 1 gebildet wird. An den nichtinvertierenden Eingang des Operationsverstärkers 1 ist dabei ein Bezugspotential M angeschlossen. Dabei bilden sein invertierender Eingang den Eingang 2 des invertierenden Spannungsverstärkers und sein Ausgang den Ausgang des Spannungsverstärkers. Der Eingang 2 ist mit einem Anschluß einer Stromquelle 16 verbunden, deren anderer Anschluß an dem Bezugspotential M liegt, wobei er mit einem Strom I gespeist wird.

Zwischen Eingang 2 und Ausgang 3 des invertierenden Spannungsverstärkers 1 sind zwei Dioden 4 und 5 antiseriell geschaltet und zwar derart, daß die Anoden beider Dioden 4 und 5 mit dem Eingang 2 bzw. dem Ausgang 3 verbunden sind und die beiden Katoden miteinander verschaltet sind. Die beiden miteinander gekoppelten Katoden der Dioden 4 und 5 wiederum sind mit dem Kollektor eines npn-Transistors 6 verbunden, dessen Emitteranschluß an das Bezugspotential M angeschlossen ist. Der Basis des Transistors 6 ist ein Tiefpaß vorangestellt, der aus einem zwischen das Bezugspotential M und die Basis des Transistors 6 geschalteten Kondensator 15 sowie aus einem einerseits an die Basis des Transistors 6 und andererseits an den Ausgang eines Operationsverstärkers 13 angeschlossenen Widerstand 14 besteht.

Der Operationsverstärker 13 bildet die Ausgangsstufe eines Differenzverstärkers, dessen Eingangsstufe durch ein aus einer Stromquelle 7 gespeistes, emittergekoppeltes npn-Transistorpaar 8, 9 sowie aus durch in die Kollektorkreise der Transistoren 8 und 9 geschaltete Widerstände gebildet wird. Im einzelnen sind die gekoppelten Emittertransistoren 8 und 9 über die Stromquelle 7 mit dem Bezugspotential M verbunden. Die Kollektoren der beiden Transistoren 8 und 9 sind über jeweils einen Widerstand 11 bzw. 10 an ein positives Versorgungspotential 12 angeschlossen. Darüber hinaus ist der Kollektor des Transistors 8 mit dem invertierenden Eingang und der Kollektor des Transistors 9 mit dem nichtinvertierenden Eingang des Operationsverstärkers 13 verschaltet. Die Eingänge des Differenzverstärkers darstellenden Basen der Transistoren 8 und 9 sind mit Ein- und Ausgang 2 und 3 des invertierenden Verstärkers 1 derart verbunden, daß die Basis des Transistors 8 mit dem Ausgang 3 und die Basis des Transistors 9 mit dem Eingang 2 gekoppelt ist.

Nachdem zuvor der prinzipielle Aufbau eines erfindungsgemäßen Impedanzverstärkers erläutert worden ist, soll im folgenden näher auf dessen Funktionsweise eingegangen werden.

Der von der Stromquelle 16 -beispielsweise einer mit einem Glasfaserkabel gekoppelten Fotodiode erzeugte Strom I setzt sich additiv aus einem Gleichanteil $I_{DC}$ und einem Wechselstromanteil $I_{AC}$ zusammen, wobei die Amplitude des Wechselstromanteils $I_{AC}$ immer kleiner oder gleich dem Gleichstromanteil $I_{DC}$ ist. Das Verhalten der Dioden 4 und 5 kann durch eine Exponentialfunktion derart beschrieben werden, daß die Spannung über der Diode gleich dem Produkt ist aus der Temperaturspannung $U_T$ und dem Logarithmus aus dem Verhältnis von dem sie durchfließenden Strom zu dem Sättigungsstrom $I_S$. Da die Diode 4 durch einen Strom durchflossen wird, der gleich der Differenz zwischen dem Kollektorstrom $I_C$ des Transistors 6 und den Gleichstromanteil $I_{DC}$ des Stromes I ist und da der Strom durch die Diode 5 gleich dem Gleichstromanteil $I_{DC}$ des Stromes I ist, ergibt sich:

$$U_1 = U_T \cdot \ln \frac{I_C - I_{DC}}{I_S}$$

$$U_2 = U_T \cdot \ln \frac{I_{DC}}{I_S} \ .$$

Die Regelung über den Differenzverstärker und den nachgeschalteten Tiefpaß erfolgt derart, daß die Spannung $U_1$ gleich der Spannung $U_2$ wird und damit der Kollektorstrom $I_C$ des Transistors 6 doppelt so groß wird wie der Gleichanteil $I_{DC}$ des Stroms I. Somit steht die Gleichstromeinstellung der Transimpedanzverstärkerschaltung fest.

Hinsichtlich des Wechselstromanteils $I_{AC}$ gilt:

$$U_1 = U_T \cdot \ln \frac{I_{DC} - I_{AC}}{I_S}$$

$$U_2 = U_T \cdot \ln \frac{I_{DC} - I_{AC}}{I_S}$$

Die Basis-Emitter-Spannungen $U_3$ und $U_4$ der Transistoren 8 und 9 ergeben sich aus den jeweils zugehörigen Kollektorströmen $I_1$ und $I_2$ wie folgt:

$$U_3 = U_T \cdot \ln \frac{I_1}{I_S}$$

$$U_4 = U_T \cdot \ln \frac{I_2}{I_S} \ .$$

Außerdem gilt, daß die Differenz zwischen den Spannungen $U_3$ und $U_4$ gleich der Differenz der Spannungen $U_1$ und $U_2$ ist, wobei die Summe der Ströme $I_1$

und $I_2$ gleich dem Strom $I_C$ sowie die differenzielle Eingangsspannung $U_5$ des Operationsverstärkers 13 gleich der mit dem Widerstandswert R der beiden Widerstände 10 und 11 multiplizierten Differenz zwischen den Strömen $I_2$ und $I_1$ ist. Daraus folgt:

$$U_1 - U_2 = U_T \cdot \ln \frac{I_C \cdot U_{AC}}{I_C \cdot R + U_{AC}} \ .$$

Daraus ergibt sich für die differenzielle Spannung:

$$U_5 = I_C \cdot R \cdot \frac{I_{AC}}{I_{DC}} \ .$$

Danach ist die differenzielle Spannung $U_5$ linear vom Wechselstromanteil $I_{AC}$ des Stromes I abhängig. Da der Betrag der Amplitude des Wechselstromanteils $I_{AC}$ proportional ist zum Gleichstromanteil $I_{DC}$ des Stroms I, ist die Amplitude der differenziellen Spannung $U_5$ unabhängig von der Amplitude des Wechselstromanteils $I_{AC}$. Daraus folgt wiederum daß der Transimpedanzwiderstand $R_T$ proportional ist zum Kehrwert der Amplitude des Wechselstromanteils $I_{AC}$.

Der Transimpedanzwiderstand $R_T$ ergibt sich aufgrund der Serienschaltung von zwei Dioden zu

$$R_T = 2 \cdot \frac{U_T}{I_{DC}} \ .$$

Aus dem Rauschstrom (Schrotrauschen) einer Diode mit $I_R^2 = 2 \cdot I_{DC} \cdot q \cdot \Delta f$ und dem Transimpedanzwiderstand $R_T$ ergibt sich eine entsprechende Rauschspannung an den beiden in Serie geschalteten Dioden 4 und 5 zu

$$U_R^2 = 4 \cdot k \cdot T \cdot \Delta f \cdot \frac{U_T}{I_{DC}} \ .$$

Damit errechnet sich der äquivaltene Eingangsrauschstrom $I_R^2$ zu

$$I_R^2 = \frac{2 \cdot k \cdot T \cdot \Delta f}{R_T} \ .$$

Demgegenüber beträgt der äquivalente Rauschstrom bei einer Beschaltung mit einem ohmschen Widerstand als Transimpedanzwiderstand gleichen Wertes

$$I_R^2 = \frac{4 \cdot k \cdot T \cdot \Delta f}{R_T} \ .$$

Der Vergleich zeigt, daß das Rauschstromquadrat bei gleich großem Transimpedanzwiderstand $R_T$ nur halb so groß ist.

**Patentansprüche**

1. Transimpedanzverstärkerschaltung mit einem invertierenden Spannungsverstärker (1), dessen Eingang (2) durch einen Eingangsstrom (I) gespeist wird und dessen Ausgang (3) eine Ausgangsspannung führt, und mit einem Kopplungsglied, das zwischen Eingang (2) und Ausgang (3) des Spannungsverstärkers (1) geschaltet ist,
**dadurch gekennzeichnet,** daß das Kopplungsglied zwei Dioden (4, 5) aufweist, die antiseriell zueinander zwischen Eingang (2) und Ausgang (3) des Spannungsverstärkers (1) geschaltet sind und deren gemeinsamer Knotenpunkt über die Laststrecke eines Transistors (6) mit einem Bezugspotential (M) verbunden ist, daß an Eingang (2) und Ausgang (3) des Spannungsverstärkers (1) je einer der beiden Eingänge eines Differenzverstärkers (7, 8, 9, 10, 11, 13) angeschlossen ist, und daß ein dem Differenzverstärker (7, 8, 9, 10, 11, 13) nachgeschalteter Tiefpaß (14, 15) an seinem Ausgang ein Ansteuersignal für den Transistor (6) bereitstellt.

**Claims**

1. Transimpedance amplifier circuit having an inverting voltage amplifier (1), whose input (2) is fed by an input cu-rrent (I) and whose output (3) carries an output voltage, and having a coupling element connected between the input (2) and the output (3) of the voltage amplifier (1),
characterized in that the coupling element has two diodes (4, 5), which are reverse-connected in series with one another between the input (2) and the output (3) of the voltage amplifier (1) and whose common node is connected to a reference-earth potential (M) via the load path of a transistor (6), in that in each case one of the two inputs of a differential amplifier (7, 8, 9, 10, 11, 13) is connected to the input (2) and the output (3) of the voltage amplifier (1), and in that a low-pass filter (14, 15) connected downstream of the differential amplifier (7, 8, 9, 10, 11, 13) provides, at its output, a drive signal for the transistor (6).

**Revendications**

1. Circuit amplificateur transimpédance comprenant un amplificateur de tension inverseur (1) dont l'entrée (2) est alimentée par un courant d'entrée (I) et dont la sortie (3) fournit une tension de sortie, et comprenant un élément de couplage qui est branché entre l'entrée (2) et la sortie (3) de l'amplificateur de tension (1), caractérisé en ce que l'élément de couplage comprend deux diodes (4, 5) qui sont branchées de manière antisérielle l'une par rapport à l'autre entre l'entrée (2) et la sortie (3) de l'amplificateur de tension (1) et dont le noeud commun est relié à un potentiel de référence (M) par le biais du trajet de charge d'un transistor (6), en ce que à l'entrée (2) et à la sortie (3) de l'amplificateur de tension (1) est reliée à chaque fois une des deux entrées d'un amplificateur différentiel (7, 8, 9, 10, 11, 13), et en ce qu'un filtre passe-bas (14, 15) branché derrière l'amplificateur différentiel (7, 8, 9, 10, 11, 13) fournit à sa sortie un signal de commande pour le transistor (6).